# EUROPEAN PATENT APPLICATION

(11) **EP 4 685 750 A1**
(43) Date of publication of application: **28.01.2026**
(21) Application number: 24773899.0
(22) Date of filing: 04.03.2024
(51) Int. Cl.: G06T 11/60

(54) **ARTICLE INFORMATION MATCHING DIAGRAM GENERATION METHOD AND APPARATUS, DEVICE, MEDIUM, AND PROGRAM PRODUCT**

(30) Priority: 20.03.2023 CN 202310272490
(71) Applicant: Jingdong Technology Holding Co., Ltd., Beijing 100176 (CN)
(72) Inventor: CAO, Junhao, Beijing 100176 (CN); GUAN, Xiaokun, Beijing 100176 (CN); ZHANG, Liping, Beijing 100176 (CN); PEI, Jiquan, Beijing 100176 (CN)
(74) Representative: Wynne-Jones IP Limited
(86) International application number: PCT/CN2024/079877
(87) International publication number: WO 2024/193331

(57) **Abstract**

Embodiments of the present disclosure provide a method and an apparatus of generating an item information collocation diagram, a device, a medium, and a program product. A specific implementation of the method includes: determining a corresponding item placement region type and a corresponding item placement scene type for each item category information in an item information group; determining a target background image and an item allocation relationship information based on a set of item placement region types, a set of item placement scene types, the item information group and a set of background images; determining at least one item information corresponding to an item placement region; determining an item position information corresponding to the at least one item information; and filling each item image into the corresponding item placement region in the target background image according to the corresponding item position information, so as to obtain an item information collocation diagram.

## Description

This application claims the benefit of priority to Chinese Patent Application No. 202310272490.X filed on March 20, 2023, which is incorporated herein by reference in its entirety.

### TECHNICAL FIELD

Embodiments of the present disclosure relate to a field of computer technology, and in particular to a method and an apparatus of generating an item information collocation diagram, a device, a medium, and a program product in a metaverse shopping process.

### BACKGROUND

When generating an item information collocation diagram, an existing method is to fill an item image into a general background image template or a background image template obtained by manual collocation, or to fill an item image into a background image including a preset annotation box according to a category of the item image.

However, the inventors found that the above-described method has the following technical problems. In a case of a new category of item information, it is needed to re-perform a manual collocation for the background image, and it is difficult to process an item having a significant scale difference from the preset annotation box, then the generated item information collocation diagram may be unreasonable or unaesthetic, and an efficiency is not high.

The above information disclosed in the background section is provided only to enhance understanding of the background of the inventive concept and therefore it may contain information that does not constitute the related art known to those ordinary skilled in the art in this country.

### SUMMARY

The summary section of the present disclosure is used to introduce concepts in a brief form, and these concepts will be described in detail in the detailed description of embodiments section. The summary section of the present disclosure is not intended to identify key features or essential features of the technical solutions sought to be protected, nor is it intended to limit the scope of the technical solutions sought to be protected.

Embodiments of the present disclosure provide a method and an apparatus of generating an item information collocation diagram, a device, a medium, and a program product, so as to solve the technical problems described in the background section.

In a first aspect, some embodiments of the present disclosure provide a method of generating an item information collocation diagram, including: determining, for an item category information comprised in each item information in a pre-acquired item information group, an item placement region type corresponding to the item category information and an item placement scene type corresponding to the item category information, where the item information in the item information group further includes an item image; determining a target background image and an item allocation relationship information corresponding to the target background image based on a set of determined item placement region types, a set of determined item placement scene types, the item information group and a pre-acquired set of background images, where the target background image includes at least one item placement region; determining, for each item placement region in the at least one item placement region, at least one item information corresponding to the item placement region based on the item allocation relationship information; determining an item position information corresponding to the at least one item information for each item placement region in the at least one item placement region; and filling each item image included in the item information group into the corresponding item placement region in the target background image according to the corresponding determined item position information, so as to obtain the item information collocation diagram.

In a second aspect, some embodiments of the present disclosure provide an apparatus of generating an item information collocation diagram, including: a first determination unit configured to determine a corresponding item placement region type and a corresponding item placement scene type for an item category information included in each item information in a pre-acquired item information group, where the item information in the item information group further includes an item image; a second determination unit configured to determine a target background image and an item allocation relationship information corresponding to the target background image based on a set of determined item placement region types, a set of determined item placement scene types, the item information group and a pre-acquired set of background images, where the target background image includes at least one item placement region; a third determination unit configured to determine, for each item placement region in the at least one item placement region, at least one item information corresponding to the item placement region based on the item allocation relationship information; a fourth determination unit configured to determine an item position information corresponding to the at least one item information for each item placement region in the at least one item placement region; and a filling unit configured to fill each item image included in the item information group into the corresponding item placement region in the target background image according to the corresponding determined item position information, so as to obtain the item information collocation diagram.

In a third aspect, some embodiments of the present disclosure provide an electronic device, including: one or more processors; and a memory having one or more programs stored thereon, where the one or more programs, when executed by the one or more processors, are configured to cause the one or more processors to implement the method described in any implementation in the first aspect.

In a fourth aspect, some embodiments of the present disclosure provide a computer-readable medium having a computer program stored thereon, where the computer program, when executed by a processor, is configured to cause the processor to implement the method described in any implementation in the first aspect.

In a fifth aspect, some embodiments of the present disclosure provide a computer program product including a computer program, where the computer program, when executed by a processor, is configured to cause the processor to implement the method described in any implementation in the first aspect.

### BRIEF DESCRIPTION OF THE DRAWINGS

Other features, advantages and aspects of embodiments of the present disclosure will become more clear with reference to the following detailed description in conjunction with the accompanying drawings. Throughout the accompanying drawings, the same or similar reference numerals refer to the same or similar elements. It should be understood that the accompanying drawings are schematic, and components and elements are not necessarily drawn to scale.
FIG. 1 to FIG. 5 show schematic diagrams of an application scenario of a method of generating an item information collocation diagram according to some embodiments of the present disclosure;
FIG. 6 shows a flowchart of a method of generating an item information collocation diagram according to some embodiments of the present disclosure;
FIG. 7 shows a flowchart of a method of generating an item information collocation diagram according to other embodiments of the present disclosure;
FIG. 8 shows a schematic structural diagram of an apparatus of generating an item information collocation diagram according to some embodiments of the present disclosure; and
FIG. 9 shows a schematic structural diagram of an electronic device for implementing some embodiments of the present disclosure.

### DETAILED DESCRIPTION OF EMBODIMENTS

Embodiments of the present disclosure will be described in more detail below with reference to the accompanying drawings. Although some embodiments of the present disclosure are shown in the accompanying drawings, it should be understood that the present disclosure may be implemented in various forms and should not be construed as limited to the embodiments set forth herein. Rather, these embodiments are provided for a thorough and complete understanding of the present disclosure. It should be understood that the accompanying drawings and embodiments of the present disclosure are only for illustrative purposes and are not intended to limit the protection scope of the present disclosure.

It should also be noted that, for the sake of description, only the parts related to the relevant invention are shown in the accompanying drawings. In a case of no conflicts, the embodiments in the present disclosure and the features in the embodiments may be combined with each other.

It should be noted that the concepts such as "first" and "second" described in the present disclosure are only used to distinguish different apparatuses, modules or units, rather than limit an order or interdependence of functions performed by these apparatuses, modules or units.

It should be noted that the words "a", "plurality of", etc. described in the present disclosure are illustrative rather than restrictive, and those skilled in the art should understand that unless otherwise clearly indicated in the context, these words should be understood as "one or more".

The names of messages or information exchanged between multiple apparatuses in embodiments of the present disclosure are only used for illustrative purposes and are not used to limit the scope of these messages or information.

The present disclosure will be described in detail below with reference to the accompanying drawings and in conjunction with embodiments.

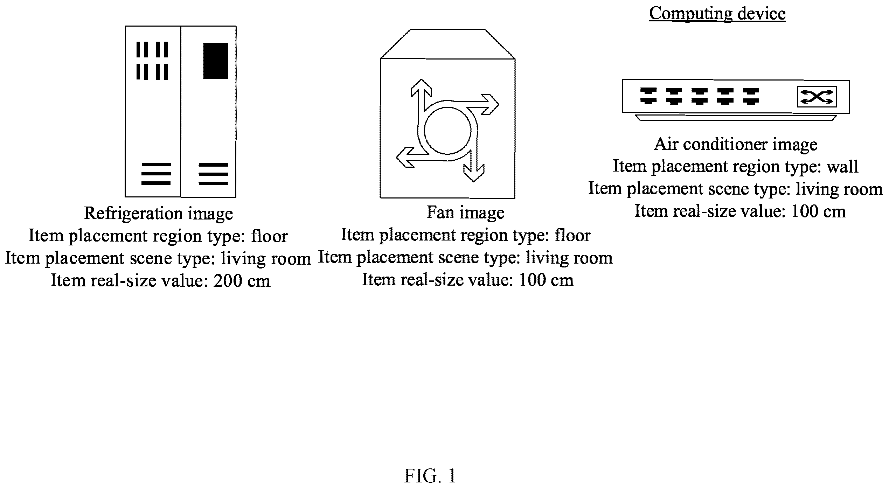

FIG. 1 to FIG. 5 show schematic diagrams of an application scenario of a method of generating an item information collocation diagram according to some embodiments of the present disclosure.

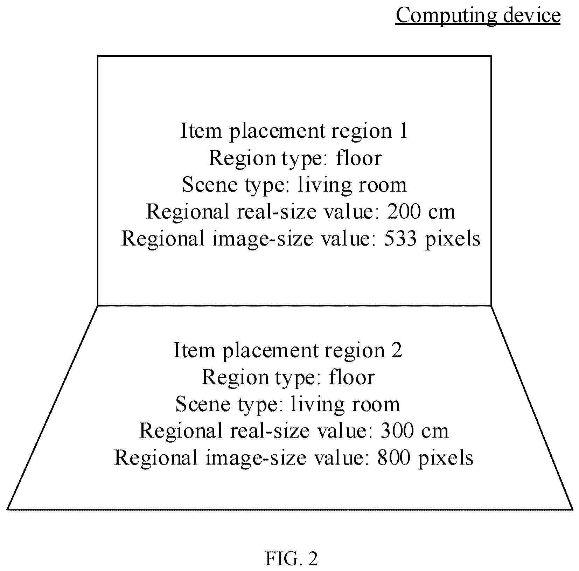

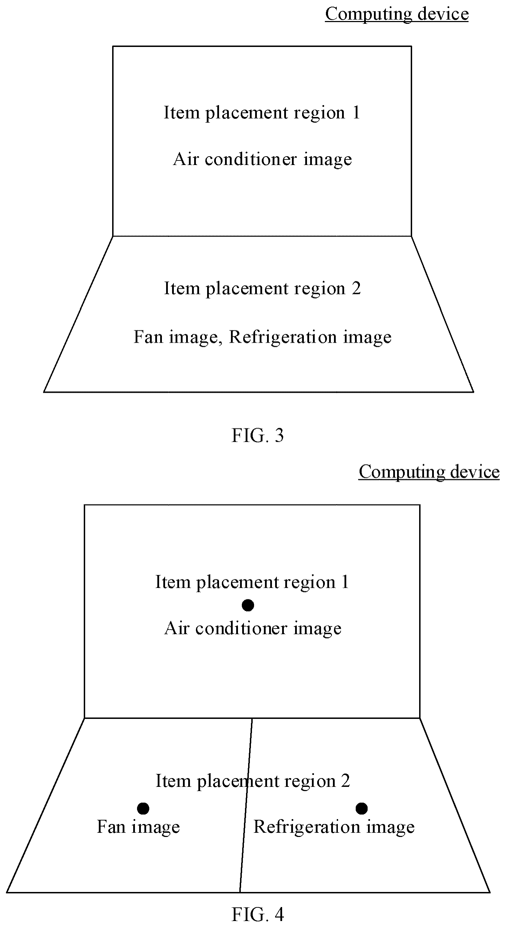

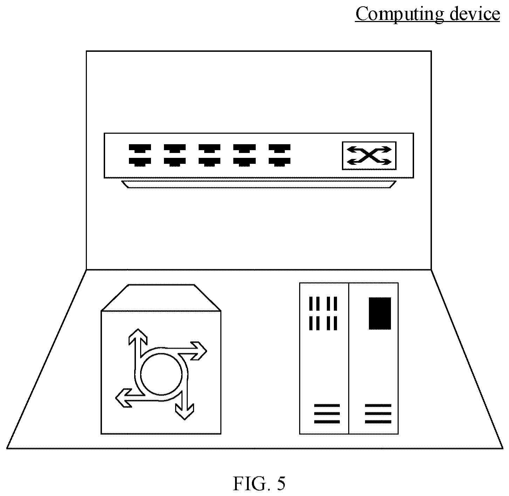

In the application scenario shown in FIG. 1 to FIG. 5, a computing device determines, for an item category information included in each item information in a pre-acquired item information group, a corresponding item placement region type and a corresponding item placement scene type. The item information in the item information group further includes an item image. FIG. 1 shows a specific example of the item information group, the corresponding item placement region types and the corresponding item placement scene types. The item information group shown in FIG. 1 is: [(refrigerator image, refrigerator category), (fan image, fan category), (air conditioner image, air conditioner category)]. For (refrigerator image, refrigerator category), the corresponding item placement region type is a floor type, and the corresponding item placement scene type is a living room type. For (fan image, fan category), the corresponding item placement region type is the floor type, and the corresponding item placement scene type is the living room type. For (air conditioner image, air conditioner category), the corresponding item placement region type is a wall type, and the corresponding item placement scene type is the living room type. Then, the computing device determines a target background image and an item allocation relationship information corresponding to the target background image based on a set of determined item placement region types, a set of determined item placement scene types, the item information group and a pre-acquired set of background images. The target background image includes at least one item placement region. FIG. 2 shows a specific example of at least one item placement region of the target background image. The target background image shown in FIG. 2 has two item placement regions: item placement region 1 and item placement region 2. The item allocation relationship information corresponding to the target background image is [(item placement region 1 - air conditioner image), (item placement region 2 - fan image, refrigerator image)]. Next, for each item placement region in the at least one item placement region, the computing device determines at least one item information corresponding to that item placement region based on the item allocation relationship information. FIG. 3 shows a specific example of the at least one item information corresponding to the item placement region. After that, the computing device determines an item position information corresponding to the at least one item information for each item placement region in the at least one item placement region. FIG. 4 shows a specific example of the item position information corresponding to the at least one item information. Finally, the computing device fills each item image included in the item information group into the corresponding item placement region in the target background image according to the corresponding determined item position information, so as to obtain an item information collocation diagram. FIG. 5 shows a specific example of the item information collocation diagram.

It should be noted that the computing device may be hardware or software. When the computing device is hardware, it may be implemented as a distributed cluster consisting of a plurality of servers or terminal devices, or it may be implemented as a single server or a single terminal device. When the computing device is embodied as software, it is installed in enumerated hardware devices. It may be implemented, for example, as a plurality of software programs or software modules for providing distributed services, or may be implemented as a single software program or software module, which are not specifically limited here. It should be understood that the number of computing devices in FIG. 1 to FIG. 5 is merely illustrative. According to implementation needs, any number of computing devices may be provided.

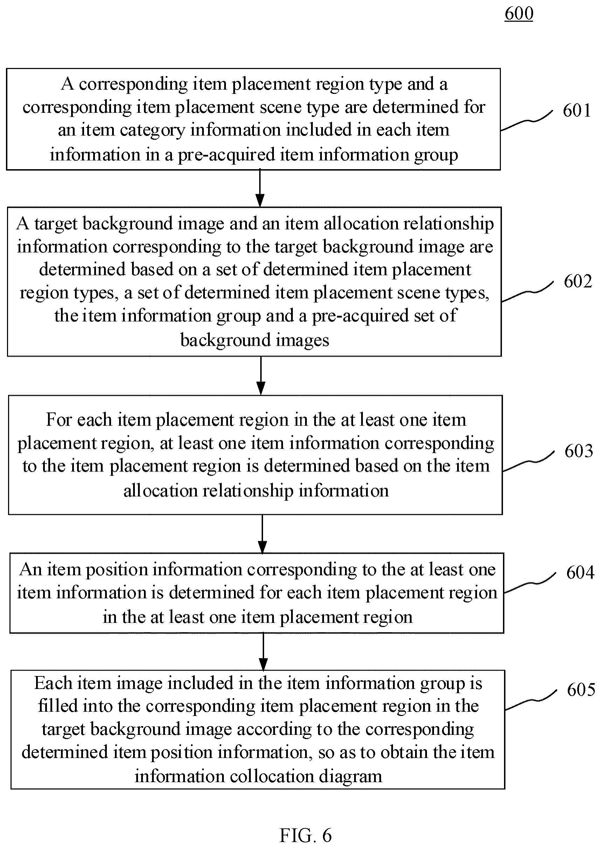

Continuing to refer to FIG. 6, a flow 600 of a method of generating an item information collocation diagram according to some embodiments of the present disclosure is shown. The method of generating the item information collocation diagram includes the following steps.

In step 601, a corresponding item placement region type and a corresponding item placement scene type are determined for an item category information included in each item information in a pre-acquired item information group.

In some embodiments, an execution entity (for example, a computing device) of the method of generating the item information collocation diagram may pre-acquire the item category information included in each item information in the item information group through a wired connection or a wireless connection, and determine the corresponding item placement region type and the corresponding item placement scene type for the item category information included in each item information in the pre-acquired item information group. The item information in the item information group further includes an item image. The item category information refers to a classification information of a item. The classification information refers to an information divided according to functions and uses of items, such as household appliances category, office supplies category, clothing category, and so on. The item category information is also a subdivided category information in the item classification information. For example, fans in the household appliances category include a desktop fan, a floor fan, a mini fan, etc., or clothes dryers in the household appliances category include a drum dryer, a hanging dryer, a handheld dryer, etc. The item placement region type includes but is not limited to at least one of a desktop type, a wall type, or a floor type. The item placement scene type includes but is not limited to at least one of a kitchen type, a living room type, a study room type, or a bedroom type.

In step 602, a target background image and an item allocation relationship information corresponding to the target background image are determined based on a set of determined item placement region types, a set of determined item placement scene types, the item information group and a pre-acquired set of background images.

In some embodiments, the execution entity may determine the target background image and the item allocation relationship information corresponding to the target background image based on the set of determined item placement region types, the set of determined item placement scene types, the item information group and the pre-acquired set of background images. The target background image includes at least one item placement region. The item placement region refers to a region in the background image that may be filled with an item image. The item allocation relationship information refers to an allocation relationship information between the item information and the item placement region.

Optionally, the set of background images may be generated by three steps as follows. In a first step, images of a plurality of scene types are acquired as a set of background images. The background image in the set of background images includes at least one item placement region. The plurality of scene types include a kitchen type, a living room type, an office type, etc. The item placement region includes a regional attribute information, which includes at least one of a regional real-size value, a corner point position information, a region type, a scene type, or a transformation matrix. The regional real-size value refers to a real size value of a long side of a region in reality, and the regional real-size value is estimated according to surrounding items. The corner point position information refers to a pixel position information of four corner points of the item placement region in the background image, and the pixel position information is represented by a position of pixels in the image. The region type includes but is not limited to at least one of a desktop type, a wall type, or a floor type. The position information of four corner points and the region type of the item placement region may be marked using a labeling tool (such as labelme). The scene type includes but is not limited to at least one of a kitchen type, a living room type, a study room type, or a bedroom type. The transformation matrix is obtained by solving a perspective transformation formula using coordinates of four corner points of a simplified representation and coordinates of four corner points of the item placement region. The four corner points of the simplified representation are represented by a rectangle with fixed length and width (x1, y1, x2, y2), where (x1, y1) represents an upper-left corner coordinate of the rectangle, and (x2, y2) represents a lower-right corner coordinate of the rectangle. In practice, it is possible to first determine an item image position information and an item image size information of an item in the rectangle, and then map the item image position information and the item image size information to the item placement region through the transformation matrix. In a second step, for each background image in the set of background images, the at least one item placement region in the background image is resized to obtain an adjusted background image. As an example, the execution entity may resize the at least one item placement region in the background image by using drawing software (such as Picart software) to obtain an adjusted background image. Optionally, resizing the at least one item placement region included in the background image may include performing a resizing step for each item placement region in the at least one item placement region, where the resizing step includes a first adjustment sub-step to a fourth adjustment sub-step. In the first adjustment sub-step, an adjustment item information is acquired according to the region type and the scene type of the item placement region, where the adjustment item information includes an item real-size value. The adjustment item information refers to an item information used as a reference for resizing, and the item real-size value refers to a real size value of a long side of the item in reality. In the second adjustment sub-step, a regional image-size value and a regional real-size value of the item placement region are determined, where the regional image-size value is represented by pixels occupied by the long side of the region in the background image, and the regional real-size value refers to a real size value of the long side of the region in reality. In the third adjustment sub-step, an item image-size value is generated according to the item real-size value, the regional image-size value and the regional real-size value, where the item image-size value is represented by pixels occupied by the long side of the item image in the background image. As an example, the execution entity may multiply the item real-size value and the regional image-size value to obtain a product value, and divide the product value by the regional real-size value to obtain an item image-size value corresponding to a same-category item information. The item real-size value refers to a real size value of the long side of the item in reality. In the fourth adjustment sub-step, the item placement region is resized according to the item image-size value. As an example, the execution entity may draw an item image in the item placement region in the background image according to the item image-size value. If the item image is too large, it is possible to increase the regional real-size value of the item placement region. If the item image is too small, it is possible to reduce the regional real-size value of the item placement region. Thus, the item placement region may be resized. In a third step, a set of adjusted background images is determined as the set of background images. In some optional implementations of some embodiments, the execution entity determining the target background image and the item allocation relationship information corresponding to the target background image based on the set of determined item placement region types, the set of determined item placement scene types, the item information group and the pre-acquired set of background images may include performing a background image selection step for the set of background images, where the background image selection step includes three steps as follow. In a first step, a background image is selected from the set of background images. In a second step, at least one region type and at least one scene type corresponding to at least one item placement region included in the selected background image are acquired. As an example, the item placement region corresponds to a region type and a scene type, the region type includes but is not limited to at least one of a desktop type, a wall type, or a floor type, and the scene type includes but is not limited to at least one of a kitchen type, a living room type, a study room type, or a bedroom type. The selected background image includes item placement region 1, for which the region type is a floor type and the scene type is a living room type. In a third step, in response to the set of item placement region types containing a subset of item placement region types having the same content as the at least one region type, and the set of item placement scene types containing a subset of item placement scene types having the same content as the at least one scene type, the item information having the item placement region type matched with the at least one region type and having the item placement scene type matched with the at least one scene type is allocated to the corresponding item placement region to obtain an allocation result. The item placement region type matched with the region type refers to the item placement region type being the same as the region type, and the item placement scene type matched with the scene type refers to the item placement scene type being the same as the scene type. As an example, the set of item placement region types includes [wall type, floor type], the at least one region type includes [wall type, floor type, desktop type], the set of item placement scene types includes [living room type], and the at least one scene type includes [living room type, study room type]. For item information 1, the item placement region type is the floor type, and the item placement scene type is the living room type. For item placement region 2, the region type is the floor type, and the scene type is the living room type. In practice, the execution entity may allocate the item information 1 to the corresponding item placement region 2.

Optionally, the background image selection step may further include two steps as follows. In a first step, it is determined whether the allocation result includes at least one same-category allocation result. The same-category allocation result represents that a plurality of same-category item information is allocated to at least one same-category item placement region. The plurality of same-category item information corresponds to the same item placement region type and the same item placement scene type. The at least one same-category item placement region corresponds to the same region type and the same scene type. As an example, for item information 1 and item information 2, their corresponding item placement region types are both the floor type, and their corresponding item placement scene types are both the living room type, then the item information 1 and the item information 2 are a plurality of same-category item information. The region type of the item placement region 1 is the floor type, and the scene type of the item placement region 1 is the living room type, then the item placement region 1 is the at least one same-category item placement region. Accordingly, allocating the item information 1 and the item information 2 to the corresponding item placement region 1 is referred to as a same-category allocation result. In a second step, in response to the allocation result including at least one same-category allocation result, a same-category allocation result selection step is performed for the at least one same-category allocation result, where the same-category allocation result selection step includes a first selection sub-step to a seventh selection sub-step. In the first selection sub-step, a same-category allocation result is selected from the at least one same-category allocation result. In the second selection sub-step, a plurality of same-category item information corresponding to the selected same-category allocation result is determined as a set of same-category item information. In the third selection sub-step, at least one same-category item placement region corresponding to the selected same-category allocation result is determined as a set of same-category item placement regions. In the fourth selection sub-step, the item image-size values corresponding to the same-category item information in the set of same-category item information are sorted in descending order to obtain a sequence of sorted item image-size values. As an example, the execution entity may first acquire the item real-size values of the same-category item information, then determine the regional image-size value and the regional real-size value of the item placement region by various methods, then multiply the item real-size value and the regional image-size value to obtain a product value, and divide the product value by the regional real-size value to obtain the item image-size value corresponding to the same-category item information. The item real-size value refers to a real size value of a long side of an item in reality, the regional real-size value refers to a real size value of a long side of a region in reality, and the regional image-size value is represented by pixels occupied by the long side of the region in the background image. In the fifth selection sub-step, the regional image-size values of the same-category item placement regions in the set of same-category item placement regions are sorted in descending order to obtain a sequence of sorted regional image-size values, where the regional image-size value is represented by pixels occupied by the long side of the region in the background image. In the sixth selection sub-step, a quantity of same-category item information in the set of same-category item information is determined to obtain a same-category item information quantity value. In the seventh selection sub-step, a quantity of same-category item placement region in the set of same-category item placement regions is determined to obtain a same-category item placement region quantity value.

Optionally, the same-category allocation result selection step further includes two steps as follows. In a first step, in response to the same-category item information quantity value being less than or equal to the same-category item placement region quantity value, the item images included in the set of same-category item information are allocated to the corresponding item placement region according to the sequence of sorted item image-size values and the sequence of sorted regional image-size values, so as to obtain a set of same-category item allocation relationships. For example, the set of same-category item allocation relationships includes [item information 3 - item placement region 1]. In a second step, a background image processing step is performed based on the set of same-category item allocation relationships, where the background image processing step includes a first processing sub-step to a third processing sub-step. In the first processing sub-step, an image size difference value corresponding to each same-category item allocation relationship in the set of same-category item allocation relationships is determined, so as to obtain a set of image size difference values. As an example, the execution entity may subtract the item image-size value of the item information 3 from the regional image-size value of the item placement region 1 to obtain an image size difference value corresponding to [item information 3 - item placement region 1]. Optionally, in response to the set of image size difference values containing no image size difference value less than a first target threshold, and a quantity of unselected same-category allocation result in the at least one same-category allocation result being greater than a second target threshold, the execution entity may re-perform the same-category allocation result selection step by using a set of unselected same-category allocation results as the at least one same-category allocation result. The first target threshold and the second target threshold may be pre-determined according to actual conditions. For example, the first target threshold and the second target threshold may be zero. In the second processing sub-step, in response to the set of image size difference values containing no image size difference value less than the first target threshold, and the quantity of unselected same-category allocation result in the at least one same-category allocation result being equal to the second target threshold, the selected background image is added as a candidate background image to a pre-built set of initial candidate background images, so as to obtain a set of candidate background images. Thus, when it is determined that all the same-category allocation results are reasonable, the selected background image is used as a candidate background image. In the third processing sub-step, in response to the set of image size difference values containing no image size difference value less than the first target threshold, and the quantity of unselected same-category allocation result in the at least one same-category allocation result being equal to the second target threshold, the set of generated at least one same-category item allocation relationship is determined as the item allocation relationship information corresponding to the candidate background image. Optionally, in response to the set of image size difference values containing an image size difference value less than the first target threshold, the execution entity may re-perform the background image selection step by using a set of unselected background images in the set of background images as a set of background images. Thus, when the set of image size difference values contains an image size difference value less than the first target threshold, it indicates that the background image needs to be removed and a new background image needs to be selected. Then a set of candidate background images may be determined from the set of background images.

Optionally, the same-category allocation result selection step may further includes: performing an item allocation relationship information generation step based on the sequence of sorted item image-size values and the sequence of sorted regional image-size values in response to the same-category item information quantity value being greater than the same-category item placement region quantity value, where the item allocation relationship information generation step includes a first generation sub-step to a seventh generation sub-step. In the first generation sub-step, the item images included in the same-category item information corresponding to first N sorted item image-size values in the sequence of sorted item image-size values are determined as a set of to-be-allocated item images, where a value of N is equal to the same-category item placement region quantity value. In the second generation sub-step, the set of to-be-allocated item images is allocated to the corresponding item placement region according to the sequence of sorted item image-size values and the sequence of sorted regional image-size values, so as to obtain a set of to-be-allocated-item allocation relationships as the set of same-category item allocation relationships. The to-be-allocated-item allocation relationship refers to a relationship of allocating the to-be-allocated item image to the corresponding item placement region. For example, the set of to-be-allocated-item allocation relationships may include [item information 1 - item placement region 2]. In the third generation sub-step, the image size difference value corresponding to each to-be-allocated-item allocation relationship in the set of to-be-allocated-item allocation relationships is determined, so as to obtain a set of allocated-image size difference values. As an example, the execution entity may subtract the item image-size value of 533 pixels of the item information 1 from the regional image-size value of 800 pixels of the item placement region 2 to obtain an image size difference value of 267 pixels corresponding to [item information 1 - item placement region 2]. Optionally, in response to the set of allocated-image size difference values containing an allocated-image size difference value less than the first target threshold, the execution entity may re-perform the background image selection step by using a set of unselected background images in the set of background images as a set of background images. Thus, when the set of allocated-image size difference values containing an allocated-image size difference value less than the first target threshold, it indicates that the background image needs to be removed and a new background image needs to be selected. Then a set of candidate background images may be determined from the set of background images. In the fourth generation sub-step, in response to the set of allocated-image size difference values containing no allocated-image size difference value less than the first target threshold, the allocated-image size difference values in the set of allocated-image size difference values are sorted in descending order to obtain a sequence of sorted allocated-image size difference values. In the fifth generation sub-step, a quantity of unallocated item image in a set of unallocated item images is determined, where the set of unallocated item images refers to a set of item images other than the set of to-be-allocated item images in the item images corresponding to the set of same-category item information. In the sixth generation sub-step, in response to the quantity of unallocated item image being less than or equal to the same-category item placement region quantity value, the item image included in the unallocated item images is allocated to the corresponding item placement region according to the sequence of sorted allocated-image size difference values and the item image-size values corresponding to the set of unallocated item images, so as to obtain a set of unallocated-item allocation relationships. In the seventh generation sub-step, the background image processing step is performed by using the set of unallocated-item allocation relationships as a set of same-category item allocation relationships. Thus, when the quantity of unallocated item image is less than or equal to the same-category item placement region quantity value, it is possible to allocate the item image included in the unallocated item image, and determine whether the background image is used as a candidate background image after the image allocation.

Optionally, in response to the quantity of unallocated item image being greater than the same-category item placement region quantity value, the execution entity may re-perform the item allocation relationship information generation step by using the quantity of unallocated item image as the same-category item information quantity value, using a sequence of sorted item image-size values other than the first N sorted item image-size values as a sequence of sorted item image-size values, and using the sequence of sorted allocated-image size difference values as a sequence of sorted regional image-size values. Thus, when the quantity of unallocated item image is greater than the same-category item placement region quantity value, the item allocation relationship information generation step is re-performed until the quantity of unallocated item image is less than or equal to the same-category item placement region quantity value, and then the allocation is completed.

Optionally, determining the target background image and the item allocation relationship information corresponding to the target background image based on the set of determined item placement region types, the set of determined item placement scene types, the item information group and the pre-acquired set of background images may further include three steps as follows. In a first step, it is determined whether the set of candidate background images is an empty set. In a second step, in response to the set of candidate background images not being an empty set, a candidate background image is randomly selected from the set of candidate background images as the target background image, and the item allocation relationship information corresponding to the selected candidate background image is determined as the item allocation relationship information corresponding to the target background image. In a third step, in response to the set of candidate background images being an empty set, a pre-acquired general background image is determined as the target background image.

In step 603, for each item placement region in the at least one item placement region, at least one item information corresponding to the item placement region is determined based on the item allocation relationship information.

In some embodiments, the execution entity may determine, for each item placement region in the at least one item placement region, at least one item information corresponding to the item placement region based on the item allocation relationship information. The item allocation relationship information may include [(item placement region 1 - air conditioner image), (item placement region 2 - fan image, refrigerator image)].

In step 604, an item position information corresponding to the at least one item information is determined for each item placement region in the at least one item placement region.

In some embodiments, the execution entity may randomly determine the item position information corresponding to the at least one item information for each item placement region in the at least one item placement region.

In step 605, the item images included in the item information group are filled into the corresponding item placement region in the target background image according to the determined item position information, so as to obtain the item information collocation diagram.

In some embodiments, the execution entity may paste the item images included in the item information group to the corresponding item placement region in the target background image according to the determined item position information, so as to obtain the item information collocation diagram. The item information collocation diagram refers to an image obtained after pasting the item images onto the target background image.

Embodiments of the present disclosure have the following beneficial effects. Through the method of generating the item information collocation diagram according to some embodiments of the present disclosure, in a case of a new category of item information or in a case of processing an item with a significant scale difference from a preset label box, it is possible to rapidly generate an item information collocation diagram, and the generated item information collocation diagram is more reasonable and beautiful. Specifically, a reason why the generated item information collocation diagram is unreasonable or unaesthetic and the efficiency is not high lies in that in a case of a new category of item information, it is needed to re-perform a manual collocation for the background image and it is difficult to process an item having a significant scale difference from the preset label box. Based on this, in the method of generating the item information collocation diagram according to some embodiments of the present disclosure, firstly, a corresponding item placement region type and a corresponding item placement scene type are determined for an item category information included in each item information in a pre-acquired item information group, where the item information in the item information group further includes an item image. Thus, in a case of a new category of item information, it is possible to rapidly allocate the new category of item information to an item placement region by determining the corresponding item placement region type and the corresponding item placement scene type, thereby avoiding a manual collocation for the new category of item information. Secondly, a target background image and an item allocation relationship information corresponding to the target background image are determined based on the set of determined item placement region types, the set of determined item placement scene types, the item information group and the pre-acquired set of background images, where the target background image includes at least one item placement region. Thus, it is possible to select a reasonable background image from the pre-acquired set of background images as the target background image, so that the selection of the background image is more reasonable, the use of background image with manual collocation may be avoided, and the efficiency of generating a background image may be improved. Furthermore, for each item placement region in the at least one item placement region, at least one item information corresponding to the item placement region is determined based on the item allocation relationship information, and an item position information corresponding to the at least one item information is determined for each of the at least one item placement region. Thus, the item image that needs to be filled into the target background image may be adjusted according to the item position information. Finally, the item images included in the item information group are filled into the corresponding item placement region in the target background image according to the determined item position information, so as to obtain the item information collocation diagram. Thus, in a case of a new category of item information, a manual collocation for the background image may be avoided. In addition, the item image is filled into the corresponding item placement region in the target background image according to the item position information, so that the generated item information collocation diagram is more reasonable and beautiful.

The above-described implementation is related to metaverse shopping and achieves a rapid generation of item information collocation diagram in a case of a new category of item information. Moreover, the generated item information collocation diagram is more reasonable and beautiful.

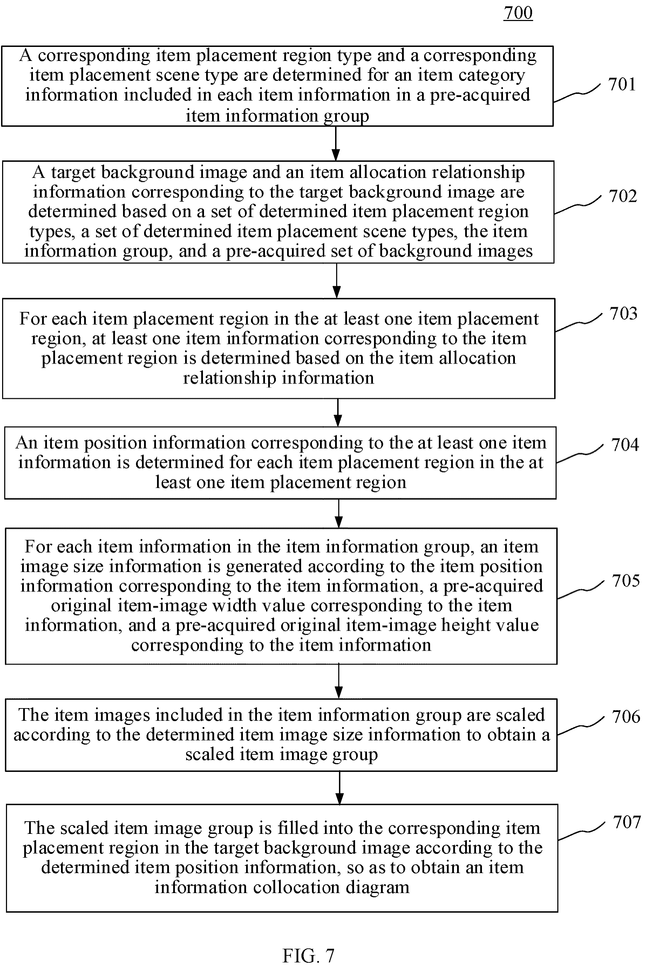

Continuing to refer to FIG. 7, a flow 700 of a method of generating an item information collocation diagram according to other embodiments is shown. The flow 700 of the method of generating the item information collocation diagram includes the following steps.

In step 701, a corresponding item placement region type and a corresponding item placement scene type are determined for an item category information included in each item information in a pre-acquired item information group.

In step 702, a target background image and an item allocation relationship information corresponding to the target background image are determined based on a set of determined item placement region types, a set of determined item placement scene types, the item information group, and a pre-acquired set of background images.

In step 703, for each item placement region in the at least one item placement region, at least one item information corresponding to the item placement region is determined based on the item allocation relationship information.

In some embodiments, for the specific implementation of steps 701 to 703 and the produced technical effects, reference may be made to steps 601 to 603 in those embodiments corresponding to FIG. 6, which will not be repeated here.

In step 704, an item position information corresponding to the at least one item information is determined for each item placement region in the at least one item placement region.

In some embodiments, the execution entity may determine the item position information corresponding to the at least one item information for each item placement region in the at least one item placement region.

In some optional implementations of some embodiments, the item position information includes an item arrangement relationship information; and the execution entity determining the item position information corresponding to the at least one item information for each item placement region in the at least one item placement region includes seven steps as follows. In a first step, the at least one item information corresponding to the item placement region is determined as a set of allocated item information, where the at least one item information corresponding to the item placement region is the item information allocated to the item placement region. In a second step, an allocated-item real-size value corresponding to each allocated item information in the set of allocated item information is acquired, so as to obtain a set of allocated-item real-size values, where the allocated-item real-size value refers to a real size value of a long side of an item in reality. In a third step, a regional image-size value and a regional real-size value of the item placement region are acquired, where the regional image-size value is represented by pixels occupied by a long side of a region in the background image, and the regional real-size value refers to a real size value of the long side of the region in reality. In a fourth step, a set of allocated-item image-size values is generated based on the set of allocated-item real-size values, the regional image-size value and the regional real-size value. As an example, the execution entity may multiply the allocated-item real-size value and the regional image-size value to obtain a product value, and then divide the product value by the regional real-size value to generate an allocated-item image-size value. In a fifth step, allocated-item image-size values in the set of allocated-item image-size values are sorted in ascending order to generate a sequence of sorted allocated-item image-size values. In a sixth step, a quantity of sorted allocated-item image-size values in the sequence of sorted allocated-item image-size values is determined. In a seventh step, an item arrangement relationship information is generated in response to the quantity of sorted allocated-item image-size values being a third target threshold, where the third target threshold is pre-determined according to actual conditions. As an example, the third target threshold is 1. When the third target threshold is 1, the generated item arrangement relationship information includes [item image 3 - item placement region 2: center placement].

Optionally, determining the item position information corresponding to the at least one item information for each item placement region in the at least one item placement region further includes two steps as follows. In a first step, in response to the quantity of sorted allocated-item image-size values being greater than the third target threshold, an item arrangement relationship information determination step is performed for the sequence of sorted allocated-item image-size values, where the item arrangement relationship information determination step includes a first determination sub-step to an eight determination sub-step. In the first determination sub-step, the item images corresponding to two smallest sorted allocated-item image-size values in the sequence of allocated-item image-size values are determined as a first item image and a second item image. In the second determination sub-step, a height ratio value and a width ratio value are generated based on the first item image and the second item image. As an example, the execution entity may acquire a height value and a width value of the first item image as a first height value and a first width value, then acquire a height value and a width value of the second item image as a second height value and a second width value, sum the first height value and the second height value to obtain a total height value, multiply the total height value by a predetermined height ratio factor to generate the height ratio value, sum the first width value and the second width value to obtain a total width value, and multiply the total width value by a predetermined width ratio factor to generate the width ratio value. The predetermined height ratio coefficient and the predetermined width ratio coefficient may be determined in advance according to actual conditions. Optionally, the execution entity generating the height ratio value and the width ratio value based on the first item image and the second item image may include: acquiring a height value and a width value of the first item image as a first height value and a first width value; acquiring a height value and a width value of the second item image as a second height value and a second width value; determining a ratio of the first height value to the second height value to obtain a height ratio value; and determining a ratio of the first width value to the second width value to obtain a width ratio value. In the third determination sub-step, in response to the height ratio value being greater than the width ratio value, a horizontal item arrangement information is generated as the item arrangement relationship information. The horizontal item arrangement information includes a left-right arrangement information and a horizontal ratio value. The horizontal ratio value is equal to the width ratio value, and the left-right arrangement information indicates a left-right placement of items. In the fourth determination sub-step, in response to the height ratio value being less than or equal to the width ratio value, a vertical item arrangement information is generated as the item arrangement relationship information. The vertical item arrangement information includes an up-down arrangement information and a vertical ratio value. The vertical ratio value is equal to the height ratio value, and the up-down arrangement information indicates an up-down arrangement of items. In the fifth determination sub-step, the first item image and the second item image are determined as an integrated item image. A height value of the integrated item image is referred to as an integrated-image height value, and a width value of the integrated item image is referred to as an integrated-image width value. The integrated-image height value is equal to a larger one of the first height value and the second height value, and the integrated-image width value is equal to a larger one of the first width value and the second width value. In the sixth determination sub-step, a sequence of updated allocated-item image-size values is generated based on the sequence of sorted allocated-item image-size values and an allocated-item image-size value corresponding to the integrated item image. In practice, the execution entity may first remove the allocated-item image-size value corresponding to the first item image and the allocated-item image-size value corresponding to the second item image from the sequence of sorted allocated-item image-size values to obtain a sequence of allocated-item image-size values after removal, and then add the allocated-item image-size value corresponding to the integrated item image to the sequence of allocated-item image-size values after removal to obtain the sequence of updated allocated-item image-size values. The allocated-item image-size value corresponding to the integrated item image is obtained by: determining an integrated item real-size value of the integrated item image, where the integrated item real-size value is equal to a larger one of the integrated-image width value and the integrated-image height value; acquiring the regional image-size value and the regional real-size value of the item placement region; multiplying the integrated item real-size value and the regional image-size value to obtain a product value; and dividing the product value by the regional real-size value to obtain the allocated-item image-size value corresponding to the integrated item image. In the seventh determination sub-step, a quantity of updated allocated-item image-size value in the sequence of updated allocated-item image-size values is determined. In the eighth determination sub-step, an item arrangement relationship information is generated in response to the quantity of updated allocated-item image-size value being equal to the third target threshold. Optionally, in response to the quantity of updated allocated-item image-size value being greater than the third target threshold, the execution entity may re-perform the item arrangement relationship information determination step by using the sequence of updated allocated-item image-size values as the sequence of sorted allocated-item image-size values. In a second step, the determined item arrangement relationship information is determined as the item arrangement relationship information corresponding to the at least one item information. Thus, it is possible to determine whether the item images are arranged left and right or up and down according to a relationship between the height ratio value and the width ratio value, then integrate the item images to obtain an integrated image as the item image, and determine the item arrangement relationship information of the item image, so that the arrangement information of each item image in the item placement region may be determined accurately.

Optionally, the item position information includes an item image position information; and the execution entity determining the item position information corresponding to the at least one item information for each item placement region in the at least one item placement region includes two steps as follows. In a first step, an item arrangement information quantity value of at least one item arrangement information is determined, where the at least one item arrangement information refers to an item arrangement information included in the item arrangement relationship information corresponding to the at least one item information, and the item arrangement information quantity value is obtained by subtracting 1 from a quantity value of item information allocated to the item placement region. As an example, the item arrangement relationship information corresponding to the at least one item information includes [(item image 1 and item image 2 - item placement region 1: left-right placement, horizontal ratio value), (integrated item image and item image 3 - item placement region 1: up-down placement, vertical ratio value)]. In a second step, for a regional simplified-representation information of the item placement region, an item image position information generation step is performed based on the item arrangement information quantity value. The regional simplified-representation information includes a regional upper-left corner coordinate and a regional lower-right corner coordinate, the regional upper-left corner coordinate includes a regional upper-left corner abscissa and a regional upper-left corner ordinate, and the regional lower-right corner coordinate includes a regional lower-right corner abscissa and a regional lower-right corner ordinate. The item image position information generation step includes a first generation sub-step to a third generation sub-step. In the first generation sub-step, a simplified representation information of a first region is determined in response to the item arrangement information quantity value being equal to a fourth target threshold, where the first region refers to a region in the item placement region, and the simplified representation information of the first region is the same as the regional simplified-representation information. The execution entity may further determine a simplified representation information of a second region, which is an empty set. As an example, the fourth target threshold may be equal to zero, which represents that one item image is allocated to the item placement region. In the second generation sub-step, a midpoint coordinate, a width value and a height value of the first region are determined. The midpoint coordinate of the first region includes a midpoint abscissa and a midpoint ordinate, the midpoint abscissa is an average of the regional upper-left corner abscissa and the regional lower-right corner abscissa, and the midpoint ordinate is an average of the regional upper-left corner ordinate and the regional lower-right corner ordinate. The width value is equal to the width value of the item placement region, and the height value is equal to the height value of the item placement region. A difference value between the regional lower-right corner abscissa and the regional upper-left corner abscissa is determined as the width value of the item placement region, and a difference value between the regional lower-right corner ordinate and the regional upper-left corner ordinate is determined as the height value of the item placement region. In the third generation sub-step, an item image position information is generated based on the midpoint coordinate, the width value and the height value of the first region as well as a transformation matrix corresponding to the item placement region. The item image position information includes but is not limited to at least one of an item information, an item-region midpoint coordinate, an item-region width value, an item-region height value, or an item arrangement relationship information. The item-region midpoint coordinate refers to a regional midpoint coordinate of the item information in the item placement region where the item information is allocated, the item-region width value refers to a regional width value of the item information in the item placement region where the item information is allocated, and the item-region height value refers to a regional height value of the item information in the item placement region where the item information is allocated. As an example, the execution entity may input the midpoint coordinate, the width value and the height value of the first region into the transformation matrix corresponding to the item placement region to generate the item image position information. The transformation matrix corresponding to the item placement region is obtained by solving a perspective transformation formula using coordinates of four corner points in the simplified representation information and coordinates of four corner points of the item placement region. The four corner points refer to abscissa points and ordinate points of the simplified representation information and the item placement region.

Optionally, the item image position information generation step further includes seven steps as follows. In a first step, an item arrangement information is selected from the at least one item arrangement information in response to the item arrangement information quantity value being greater than the fourth target threshold, where the item arrangement information includes a horizontal item arrangement information or a vertical item arrangement information. As an example, the horizontal item arrangement information includes (item image 1 and item image 2 - item placement region 1: left-right placement, horizontal ratio value), and the vertical item arrangement information includes (integrated item image and item image 3 - item placement region 1: up-down placement, vertical ratio value). The fourth target threshold may be greater than 0, which represents that a plurality of item images are allocated to the item placement region. In a second step, in response to the item arrangement information being the vertical item arrangement information, the item placement region is divided into a first vertical division region and a second vertical division region as a first division region and a second division region according to a height division value, where the height division value is a product value of the height value of the item placement region and the vertical ratio value included in the item arrangement information. The simplified representation information of the first division region includes a first upper-left corner coordinate and a first lower-right corner coordinate. The first upper-left corner coordinate includes a first upper-left corner abscissa and a first upper-left corner ordinate, the first upper-left corner abscissa is the same as the regional upper-left corner abscissa, and the first upper-left corner ordinate is the same as the regional upper-left corner ordinate. The first lower-right corner coordinate includes a first lower-right corner abscissa and a first lower-right corner ordinate, the first lower-right corner abscissa is a sum of the first upper-left corner abscissa and the width value of the item placement region, and the first lower-right corner ordinate is a sum of the first upper-left corner ordinate and the height division value. The simplified representation information of the second division region includes a second upper-left corner coordinate and a second lower-right corner coordinate. The second upper-left corner coordinate includes a second upper-left corner abscissa and a second upper-left corner ordinate, the second upper-left corner abscissa is the same as the regional upper-left corner abscissa, and the second upper-left corner ordinate is a sum of the regional upper-left corner ordinate and the height division value. The second lower-right corner coordinate includes a second lower-right corner abscissa and a second lower-right corner ordinate, the second lower-right corner abscissa is a sum of the regional upper-left corner abscissa and the width value of the item placement region, and the second lower-right corner ordinate is the same as the regional lower-right corner ordinate. In a third step, in response to the item arrangement information being the horizontal item arrangement information, the item placement region is divided into a first horizontal division region and a second horizontal division region as a first division region and a second division region according to a width division value, where the width division value is a product value of the width value of the item placement region and the horizontal ratio value included in the item arrangement information. The simplified representation information of the first division region includes a first upper-left corner coordinate and a first lower-right corner coordinate. The first upper-left corner coordinate includes a first upper-left corner abscissa and a first upper-left corner ordinate, the first upper-left corner abscissa is the same as the regional upper-left corner abscissa, and the first upper-left corner ordinate is the same as the regional upper-left corner ordinate. The first lower-right corner coordinate includes a first lower-right corner abscissa and a first lower-right corner ordinate, the first lower-right corner abscissa is a sum of the first upper-left corner abscissa and the width division value, and the first lower-right corner ordinate is the same as the regional lower-right corner ordinate. The simplified representation information of the second division region includes a second upper-left corner coordinate and a second lower-right corner coordinate. The second upper-left corner coordinate includes a second upper-left corner abscissa and a second upper-left corner ordinate, the second upper-left corner abscissa is a sum of the regional upper-left corner abscissa and the width division value, and the second upper-left corner ordinate is the same as the regional upper-left corner ordinate. The second lower-right corner coordinate includes a second lower-right corner abscissa and a second lower-right corner ordinate, the second lower-right corner abscissa is the same as the regional lower-right corner abscissa, and the second lower-right corner ordinate is the same as the regional lower-right corner ordinate. In a fourth step, a division midpoint coordinate, a division width value and a division height value of the first division region are determined. The division midpoint coordinate includes a division midpoint abscissa and a division midpoint ordinate, the division midpoint abscissa is an average of the regional upper-left corner abscissa and the regional lower-right corner abscissa, and the division midpoint ordinate is an average of the regional upper-left corner ordinate and the regional lower-right corner ordinate. The division width value is equal to the width value of the item placement region, and the division height value is equal to the height value of the item placement region. In a fifth step, the item image position information is generated based on the division midpoint coordinate, the division width value and the division height value of the first division region as well as the transformation matrix corresponding to the item placement region. As an example, the execution entity may input the division midpoint coordinate, the division width value and the division height value of the first division region into the transformation matrix corresponding to the item placement region to generate the item image position information. In a sixth step, the item image position information generation step is re-performed by using the simplified representation information of the second division region as the regional simplified-representation information, and using a value obtained by subtracting 1 from the item arrangement information quantity value as an item arrangement information quantity value. In a seventh step, the generated item image position information is determined as the item image position information corresponding to the at least one item information.

In step 705, for each item information in the item information group, an item image size information is generated according to the item position information corresponding to the item information, a pre-acquired original item-image width value corresponding to the item information, and a pre-acquired original item-image height value corresponding to the item information.

In some embodiments, the execution entity may generate the item image size information for each item information in the item information group according to the item position information corresponding to the item information, the pre-acquired original item-image width value corresponding to the item information, and the pre-acquired original item-image height value corresponding to the item information.

In some optional implementations of some embodiments, the item image position information includes an item-region width value and an item-region height value; and the execution entity generating the item image size information for each item information in the item information group according to the item position information corresponding to the item information, the pre-acquired original item-image width value corresponding to the item information and the pre-acquired original item-image height value corresponding to the item information may include eight steps as follows. In a first step, in response to determining that the item arrangement information corresponding to the item information is a horizontal item arrangement information, an item width ratio value is determined based on the item-region width value and the original item image width value. As an example, the execution entity may divide the item-region width value by the original item image width value to obtain a width quotient value, and multiply the width quotient value by 1.25 to obtain an item width ratio value. In a second step, a product of the item width ratio value and the original item image width value is determined as a target width value. In a third step, a product of the item width ratio value and the original item image height value is determined as a target height value. In a fourth step, the target width value and the target height value are determined as the item image size information. In a fifth step, in response to determining that the item arrangement information corresponding to the item information is a vertical item arrangement information, an item height ratio value is determined based on the item-region height value and the original item image height value. As an example, the execution entity may divide the item-region height value by the original item image height value to obtain a height quotient value, and multiply the height quotient value by 1.25 to obtain an item height ratio value. In a sixth step, a product of the item height ratio value and the original item image width value is determined as a target width value. In a seventh step, a product of the item height ratio value and the original item image height value is determined as a target height value. In an eighth step, the target width value and the target height value are determined as the item image size information.

In step 706, the item images included in the item information group are scaled according to the determined item image size information to obtain a scaled item information group.

In some embodiments, the execution entity may scale the item images included in the item information group to the corresponding item image size information according to the determined item image size information, so as to obtain a scaled item image group.

In step 707, the scaled item information group is filled into the corresponding item placement region in the target background image according to the determined item position information, so as to obtain an item information collocation diagram.

In some embodiments, the execution entity may fill the scaled item information group into the corresponding item placement region in the target background image according to the item-region midpoint coordinates included in the determined item image position information, so as to obtain the item information collocation diagram. The item image position information is a position information included in the item position information.

As shown in FIG. 7, different from the description of some embodiments corresponding to FIG. 6, the flow 700 of the method of generating the item information collocation diagram in some embodiments corresponding to FIG. 7 involves adjusting the position and size of the item image according to the item position information and the item image size information of the item information. In the solutions described in these embodiments, the item arrangement relationship information is determined first, then the item image position information is determined using the item arrangement relationship information and the regional simplified-representation information of the item placement region, and then the item image size information is determined according to the item image position information. Thus, the position and size of the item image in the target background image may be adjusted dynamically, and the generated item information collocation diagram is more reasonable and beautiful.

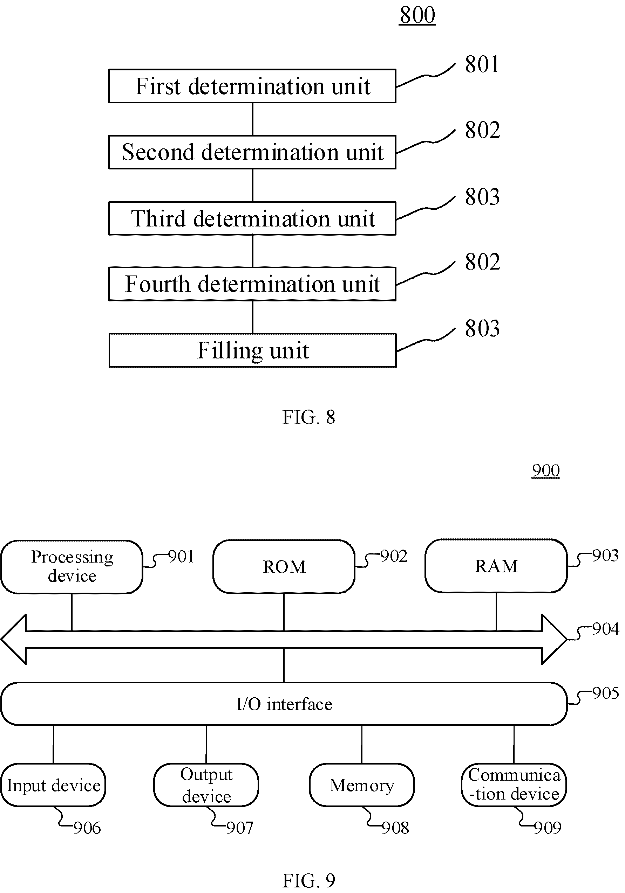

Continuing to refer to FIG. 8, as an implementation of the methods shown in the figures, the present disclosure provides some embodiments for an apparatus of generating an item information collocation diagram. These embodiments for apparatus correspond to the embodiments for method shown in FIG. 6, and the apparatus is specifically applied to various electronic devices.

As shown in FIG. 8, an apparatus 800 of generating an item information collocation diagram in some embodiments includes a first determination unit 801, a second determination unit 802, a third determination unit 803, a fourth determination unit 804 and a filling unit 805. The first determination unit 801 is configured to determine a corresponding item placement region type and a corresponding item placement scene type for an item category information included in each item information in a pre-acquired item information group, where the item information in the item information group further includes an item image. The second determination unit 802 is configured to determine a target background image and an item allocation relationship information corresponding to the target background image based on a set of determined item placement region types, a set of determined item placement scene types, the item information group and a pre-acquired set of background images, where the target background image includes at least one item placement region. The third determination unit 803 is configured to determine, for each item placement region in the at least one item placement region, at least one item information corresponding to the item placement region based on the item allocation relationship information. The fourth determination unit 804 is configured to determine an item position information corresponding to the at least one item information for each item placement region in the at least one item placement region. The filling unit 805 is used to fill the item images included in the item information group into the corresponding item placement region in the target background image according to the determined item position information, so as to obtain the item information collocation diagram.

Optionally, the filling unit 805 is used to: generate an item image size information for each item information in the item information group according to the item position information corresponding to the item information, a pre-acquired original item image width value corresponding to the item information, and a pre-acquired original item image height value corresponding to the item information; scale the item images included in the item information group according to the generated item image size information, so as to obtain a scaled item image group; and fill the scaled item image group into the corresponding item placement region in the target background image according to the determined item position information, so as to obtain the item information collocation diagram.

Optionally, the second determination unit 802 is configured to: perform a background image selection step for the set of background images, where the background image selection step includes: selecting a background image from the set of background images; acquiring at least one region type corresponding to at least one item placement region in the selected background image and at least one scene type corresponding to the at least one item placement region in the selected background image; and allocating the item information having the item placement region type matched with the at least one region type and having the item placement scene type matched with the at least one scene type to the corresponding item placement region to obtain an allocation result, in response to the set of item placement region types containing a subset of item placement region types having the same content as the at least one region type, and the set of item placement scene types containing a subset of item placement scene types having the same content as the at least one scene type.

Optionally, the second determination unit 802 is configured so that the background image selection step further includes:: determining whether the allocation result includes at least one same-category allocation result, where the same-category allocation result represents a plurality of same-category item information being allocated to at least one same-category item placement region, the plurality of same-category item information corresponds to the same item placement region type and the same item placement scene type, and the at least one same-category item placement region corresponds to the same region type and the same scene type; and performing a same-category allocation result selection step for at least one same-category allocation result in response to the allocation result including the at least one same-category allocation result, where the same-category allocation result selection step includes: selecting a same-category allocation result from the at least one same-category allocation result; determining the plurality of same-category item information corresponding to the selected same-category allocation result as a set of same-category item information; determining the at least one same-category item placement region corresponding to the selected same-category allocation result as a set of same-category item placement regions; sorting item image-size values corresponding to the same-category item information in the set of same-category item information in descending order, so as to obtain a sequence of sorted item image-size values; sorting regional image-size values of the same-category item placement regions in the set of same-category item placement regions in descending order, so as to obtain a sequence of sorted regional image-size values; determining a quantity of the same-category item information in the set of same-category item information to obtain a same-category item information quantity value; and determining a quantity of the same-category item placement regions in the set of same-category item placement regions to obtain a same-category item placement region quantity value.

Optionally, the second determination unit 802 is configured so that the same-category allocation result selection step further includes: allocating, according to the sequence of sorted item image-size values and the sequence of sorted regional image-size values, the item images included in the set of same-category item information to the corresponding item placement region to obtain a set of same-category item allocation relationships, in response to the same-category item information quantity value being less than or equal to the same-category item placement region quantity value; and performing a background image processing step based on the set of same-category item allocation relationships, where the background image processing step includes: determining an image size difference value corresponding to each same-category item allocation relationship in the set of same-category item allocation relationships, so as to obtain a set of image size difference values; adding the selected background image as a candidate background image to a pre-built set of initial candidate background images to obtain a set of candidate background images, in response to the set of image size difference values containing no image size difference value less than a first target threshold, and a quantity of unselected same-category allocation result in the at least one same-category allocation result being equal to a second target threshold; and determining a set of determined at least one same-category item allocation relationship as the item allocation relationship information corresponding to the candidate background image, in response to the set of image size difference values containing no image size difference value less than the first target threshold, and the quantity of unselected same-category allocation result in the at least one same-category allocation result being equal to the second target threshold.

Optionally, the second determination unit 802 is configured so that the same-category allocation result selection step further includes: performing an item allocation relationship information generation step based on the sequence of sorted item image-size values and the sequence of sorted regional image-size values in response to the same-category item information quantity value being greater than the same-category item placement region quantity value, where the item allocation relationship information generation step includes: determining the item images included in the same-category item information corresponding to first N sorted item image-size values in the sequence of sorted item image-size values as a set of to-be-allocated item images, where a value of N is equal to the same-category item placement region quantity value; allocating the set of to-be-allocated item images to the corresponding item placement region according to the sequence of sorted item image-size values and the sequence of sorted regional image-size values, so as to obtain a set of to-be-allocated item allocation relationships as a set of same-category item allocation relationships; determining an image size difference value corresponding to each to-be-allocated item allocation relationship in the set of to-be-allocated item allocation relationships, so as to obtain a set of allocated-image size difference values; sorting the set of allocated-image size difference values in descending order to obtain a sequence of sorted allocated-image size difference values, in response to the set of allocated-image size difference values containing no allocated-image size difference value less than the first target threshold; determining a quantity of unallocated item image in a set of unallocated item images, where the set of unallocated item images is a set of item images other than the set of to-be-allocated item images in the item images corresponding to the set of same-category item information; allocating, according to the item image-size values corresponding to the set of unallocated item images and the sequence of sorted allocated-image size difference values, the unallocated item images to the corresponding item placement region to obtain a set of unallocated-item allocation relationships, in response to the quantity of unallocated item image being less than or equal to the same-category item placement region quantity value; and performing the background image processing step by using the set of unallocated-item allocation relationships as a set of same-category item allocation relationships.

Optionally, the second determination unit 802 is configured to: determine whether the set of candidate background images is an empty set; and select a candidate background image from the set of candidate background images as the target background image and determining the item allocation relationship information corresponding to the selected candidate background image as the item allocation relationship information corresponding to the target background image, in response to the set of candidate background images not being an empty set; or determine a pre-acquired general background image as the target background image in response to the set of candidate background images being an empty set.

Optionally, the item position information includes an item arrangement relationship information; and the fourth determination unit 804 is configured to: determine at least one item information corresponding to the item placement region as a set of allocated item information; acquire an allocated-item real-size value corresponding to each allocated item information in the set of allocated item information, so as to obtain a set of allocated-item real-size values; acquire a regional image-size value and a regional real-size value of the item placement region; generate a set of allocated-item image-size values based on the set of allocated-item real-size values, the regional image-size value and the regional real-size value; sort allocated-item image-size values in the set of allocated-item image-size values in ascending order to generate a sequence of sorted allocated-item image-size values; determine a quantity of sorted allocated-item image-size values in the sequence of sorted allocated-item image-size values; and generate the item arrangement relationship information in response to the quantity of sorted allocated-item image-size values being a third target threshold.

Optionally, the fourth determination unit 804 is configured to: perform an item arrangement relationship information determination step for the sequence of sorted allocated-item image-size values in response to the quantity of the sorted allocated-item image-size values being greater than the third target threshold, where the item arrangement relationship information determination step includes: determining the item images corresponding to two smallest sorted item image-size values in the sequence of sorted allocated-item image-size values as a first item image and a second item image; generating a height ratio value and a width ratio value based on the first item image and the second item image; generating a horizontal item arrangement information as the item arrangement relationship information in response to the height ratio value being greater than the width ratio value, where the horizontal item arrangement information includes a left-right arrangement information and a horizontal ratio value, and the horizontal ratio value is equal to the width ratio value; generating a vertical item arrangement information as the item arrangement relationship information in response to the height ratio value being less than or equal to the width ratio value, where the vertical item arrangement information includes an up-down arrangement information and a vertical ratio value, and the vertical ratio value is equal to the height ratio value; determining the first item image and the second item image as an integrated item image; generating a sequence of updated allocated-item image-size values based on the sequence of sorted allocated-item image-size values and the allocated-item image-size value corresponding to the integrated item image; determining a quantity of updated allocated-item image-size value in the sequence of updated allocated-item image-size values; and generating the item arrangement relationship information in response to the quantity of updated allocated-item image-size value being the third target threshold; and determining the generated item arrangement relationship information as the item arrangement relationship information corresponding to the at least one item information.

Optionally, the fourth determination unit 804 is configured to: acquire a height value and a width value of the first item image as a first height value and a first width value; acquire a height value and a width value of the second item image as a second height value and a second width value; determine a ratio of the first height value to the second height value to obtain the height ratio value; and determine a ratio of the first width value to the second width value to obtain the width ratio value.

Optionally, the item position information includes an item image position information; and the fourth determination unit 804 is configured to: determine an item arrangement information quantity value of at least one item arrangement information, where the at least one item arrangement information is an item arrangement information included in the item arrangement relationship information corresponding to the at least one item information; and perform an item image position information generation step for a regional simplified-representation information of the item placement region based on the item arrangement information quantity value, where the regional simplified-representation information includes a regional upper-left corner coordinate and a regional lower-right corner coordinate, and the item image position information generation step includes: determining a simplified representation information of a first region in response to the item arrangement information quantity value being equal to a fourth target threshold, where the first region is a region in the item placement region, and the simplified representation information of the first region is the same as the regional simplified-representation information; determining a midpoint coordinate, a width value and a height value of the first region; and generating the item image position information based on the midpoint coordinate, the width value and the height value of the first region as well as a transformation matrix corresponding to the item placement region, where the item image position information includes at least one of an item information, an item-region midpoint coordinate, an item-region width value, an item-region height value, or an item arrangement relationship information.

Optionally, the fourth determination unit 804 is configured so that the item image position information generation step further includes: selecting an item arrangement information from the at least one item arrangement information in response to the item arrangement information quantity value being greater than the fourth target threshold, where the item arrangement information includes a horizontal item arrangement information or a vertical item arrangement information; dividing the item placement region into a first vertical division region and a second vertical division region as a first division region and a second division region according to a height division value, in response to the item arrangement information being the vertical item arrangement information; dividing the item placement region into a first horizontal division region and a second horizontal division region as the first division region and the second division region according to a width division value, in response to the item arrangement information being the horizontal item arrangement information; determining a division midpoint coordinate, a division width value and a division height value of the first division region; generating the item image position information based on the division midpoint coordinate, the division width value and the division height value of the first division region as well as the transformation matrix corresponding to the item placement region; re-performing the item image position information generation step by using a simplified representation information of the second division region as the regional simplified-representation information and using a value obtained by subtracting 1 from the item arrangement information quantity value as an item arrangement information quantity value; and determining the generated item image position information as the item image position information corresponding to the at least one item information.

Optionally, the item image position information includes an item-region width value and an item-region height value; and the filling unit 805 is configured to: in response to determining that the item arrangement information corresponding to the item information is the horizontal item arrangement information, determine an item width ratio value based on the item-region width value and the original item image width value, determine a product of the item width ratio value and the original item image width value as a target width value, determine a product of the item width ratio value and the original item image height value as a target height value, and determine the target width value and the target height value as the item image size information; or in response to determining that the item arrangement information corresponding to the item information is the vertical item arrangement information, determine an item height ratio value based on the item-region height value and the original item image height value, determine a product of the item height ratio value and the original item image width value as a target width value, determine a product of the item height ratio value and the original item image height value as a target height value, and determine the target width value and the target height value as the item image size information.

Optionally, the first determination unit 801 is configured so that the set of background images is generated by: acquire images of a plurality of scene types as a set of background images, where a background image in the set of background images includes at least one item placement region; resizing, for each background image in the set of background images, the at least one item placement region included in the background image to obtain an adjusted background image; and determining a set of adjusted background images as the set of background images.

Optionally, the first determination unit 801 is configured so that the resizing the at least one item placement region included in the background image includes: performing a resizing step for each item placement region in the at least one item placement region, where the resizing step includes: acquiring an adjustment item information according to the region type and the scene type of the item placement region, where the adjustment item information includes an item real-size value; determining a regional image-size value and a regional real-size value of the item placement region; generating an item image-size value according to the item real-size value, the regional image-size value and the regional real-size value; and resizing the item placement region according to the item image-size value.

It should be understood that the units in the apparatus 800 correspond to the steps in the method described with reference to FIG. 6. Therefore, the operations, features and beneficial effects described above for the method are also applicable to the apparatus 600 and the units included therein, which will not be repeated here.

Referring to FIG. 9, which shows a schematic structural diagram of an electronic device (e.g., the computing device in FIG. 1) 900 suitable for implementing some embodiments of the present disclosure. The electronic device in some embodiments of the present disclosure includes but is not limited to mobile terminals such as mobile phone, laptop computer, digital broadcast receiver, PDA (personal digital assistant), PAD (tablet computer), PMP (portable multimedia player), vehicle-mounted terminal (such as vehicle-mounted navigation terminal), etc., and fixed terminals such as digital TV, desktop computer, etc. The electronic device shown in FIG. 9 is merely an example and should not limit the functions and scope of use of the embodiments of the present disclosure.

As shown in FIG. 9, the electronic device 900 includes a processing device (such as a central processing unit, a graphics processing unit, etc.) 901, which performs various appropriate actions and processes according to a program stored in a read-only memory (ROM) 902 or a program loaded from a memory 908 to a random access memory (RAM) 903. Various programs and data required for the operation of the electronic device 900 are stored in the RAM 903. The processing device 901, the ROM 902 and the RAM 903 are connected to each other through a bus 904. An input/output (I/O) interface 905 is also connected to the bus 904 .

Typically, the following devices are connected to the I/O interface 905: an input device 906 including, for example, a touch screen, a touchpad, a keyboard, a mouse, a camera, a microphone, an accelerometer, a gyroscope, etc.; an output device 907 including, for example, a liquid crystal display (LCD), a speaker, a vibrator, etc.; a memory 908 including, for example, a magnetic tape, a hard disk, etc.; and a communication device 909. The communication device 909 allows the electronic device 900 to communicate with other devices in a wireless or wired manner to exchange data. Although FIG. 9 shows an electronic device 900 having various devices, it should be understood that it is not required to implement or possess all of the devices shown. More or fewer devices may be implemented or provided alternatively. Each block shown in FIG. 9 represents one device, and may also represent a plurality of devices as necessary.

In particular, according to some embodiments of the present disclosure, the processes described above with reference to the flowcharts are implemented as computer software programs. For example, some embodiments of the present disclosure include a computer program product, which includes a computer program carried on a computer-readable medium, where the computer program contains program codes for executing the methods shown in the flowcharts. In some such embodiments, the computer program is downloaded and installed from a network via the communication device 909, or installed from the memory 908, or installed from the ROM 902. When the computer program is executed by the processing device 901, the functions defined in the methods of some embodiments of the present disclosure are performed.

It should be noted that the computer-readable medium described in some embodiments of the present disclosure is a computer-readable signal medium or a computer-readable storage medium or any combination of the two. The computer-readable storage medium may be, for example but not limited to, electronic, magnetic, optical, electromagnetic, infrared, or semiconductor systems, apparatuses, or devices, or any combination of the above. More specific examples of the computer-readable storage medium include, but are not limited to, an electrical connection having one or more wires, a portable computer disk, a hard disk, a random access memory (RAM), a read-only memory (ROM), an erasable programmable read-only memory (EPROM or flash memory), optical fibers, a portable compact disk-read-only memory (CD-ROM), an optical memory, a magnetic memory, or any suitable combination thereof. In some embodiments of the present disclosure, the computer-readable storage medium is any tangible medium that may contain or store a program for use by or in connection with an instruction execution system, apparatus, or device. In some embodiments of the present disclosure, the computer-readable signal medium includes a data signal propagated in baseband or as part of a carrier wave, in which the computer-readable program code is carried. Such a propagated data signal may take any of a variety of forms, including but not limited to electromagnetic signals, optical signals, or any suitable combination thereof. The computer-readable signal medium is also any computer-readable medium other than computer-readable storage medium, which may send, propagate or transmit a program for use by or in connection with an instruction execution system, apparatus, or device. The program code embodied on the computer-readable medium may be transmitted using any appropriate medium, including but not limited to wire, optical cable, RF (radio frequency), etc., or any suitable combination thereof.

In some embodiments, a client and a server may communicate using any currently known or later developed network protocol such as HTTP (HyperText Transfer Protocol), and may be interconnected with any form or medium of digital data communication (e.g., a communication network). Examples of the communication network include a local area network ("LAN"), a wide area network ("WAN"), an internetwork (e.g., the Internet), and a peer-to-peer network (e.g., an ad hoc peer-to-peer network), as well as any currently known or later developed network.

The computer-readable medium may be included in the electronic device, or exist separately without being incorporated into the electronic device. The computer-readable medium may carry one or more programs. When executed by the electronic device, the one or more programs may cause the electronic device to: determine a corresponding item placement region type and a corresponding item placement scene type for an item category information included in each item information in a pre-acquired item information group, where the item information in the item information group further includes an item image; determine a target background image and an item allocation relationship information corresponding to the target background image based on a set of determined item placement region types, a set of determined item placement scene types, the item information group and a pre-acquired set of background images, where the target background image includes at least one item placement region; determine, for each item placement region in the at least one item placement region, at least one item information corresponding to the item placement region based on the item allocation relationship information; determine an item position information corresponding to the at least one item information for each item placement region in the at least one item placement region; and fill the item images included in the item information group into the corresponding item placement region in the target background image according to the determined item position information, so as to obtain an item information collocation diagram.

Computer program code for performing operations of some embodiments of the present disclosure may be written in one or more programming languages or a combination thereof. The programming languages include object-oriented programming languages such as Java, Smalltalk, C++, and further include conventional procedural programming languages such as "C" language or similar programming languages. The program code may be executed entirely on a user computer, partly on a user computer, as a stand-alone software package, partly on a user computer and partly on a remote computer, or entirely on a remote computer or a server. In a case of a remote computer, the remote computer may be connected to a user computer through any type of network, including a local area network (LAN) or a wide area network (WAN), or to an external computer (e.g., through the Internet using an Internet service provider).

The flowcharts and block diagrams in the accompanying drawings illustrate architectures, functions and operations that may be implemented by systems, methods and computer program products according to various embodiments of the present disclosure. In this regard, each block in the flowchart or block diagram represents a module, a program segment, or a portion of code, which contains one or more executable instructions for implementing specified logical functions. It should also be noted that in some alternative implementations, the functions noted in the blocks may occur in an order different from that noted in the figures. For example, two successively represented blocks may be actually executed substantially in parallel, or may sometimes be executed in the reverse order, depending on the functions involved. It should also be noted that each block in the block diagrams and/or flowcharts, and combinations of blocks in the block diagrams and/or flowcharts, may be implemented by a dedicated hardware-based system that performs specified function or operation, or by a combination of dedicated hardware and computer instructions.

The units described in some embodiments of the present disclosure may be implemented in the form of software, or may be implemented in the form of hardware. The described units may also be disposed in a processor, and for example, may be described as: a processor includes a first determination unit, a second determination unit, a third determination unit, a fourth determination unit and a filling unit. The names of these units do not constitute a limitation of these units themselves in some cases. For example, the first determination unit may also be described as "a unit configured to determine a corresponding item placement region type and a corresponding item placement scene type for an item category information included in each item information in a pre-acquired item information group".

The functions described above herein are at least partially performed by one or more hardware logic components. For example and without limitation, exemplary types of hardware logic components used include: field programmable gate array (FPGA), application specific integrated circuits (ASIC), application specific standard product (ASSP), system on chip (SOC), complex programmable logic device (CPLD), and the like.

Some embodiments of the present disclosure further provide a computer program product, including a computer program, where the computer program may implement any one of the method of sending request data when executed by a processor.

The above descriptions are merely some preferred embodiments of the present disclosure and illustrations of the technical principles used. Those skilled in the art should understand that the scope of the invention involved in the embodiments of the present disclosure is not limited to the technical solutions formed by a specific combination of technical features, but should also cover other technical solutions formed by any combination of technical features or their equivalent features without departing from the inventive concept, for example, a technical solution formed by replacing a feature with a technical feature having a similar function disclosed in the embodiments of the present disclosure (but not limited to) with each other.

## Claims

1. A method of generating an item information collocation diagram, comprising:
determining, for an item category information comprised in each item information in a pre-acquired item information group, an item placement region type corresponding to the item category information and an item placement scene type corresponding to the item category information, wherein the item information in the item information group further comprises an item image;
determining a target background image and an item allocation relationship information corresponding to the target background image based on a set of determined item placement region types, a set of determined item placement scene types, the item information group and a pre-acquired set of background images, wherein the target background image comprises at least one item placement region;
determining, for each item placement region in the at least one item placement region, at least one item information corresponding to the item placement region based on the item allocation relationship information;
determining an item position information corresponding to the at least one item information for each item placement region in the at least one item placement region; and
filling each item image comprised in the item information group into the corresponding item placement region in the target background image according to the corresponding determined item position information, so as to obtain the item information collocation diagram.

2. The method according to claim 1, wherein the filling each item image comprised in the item information group into the corresponding item placement region in the target background image according to the corresponding determined item position information so as to obtain the item information collocation diagram comprises:
generating an item image size information for each item information in the item information group according to the item position information corresponding to the item information, a pre-acquired original item image width value corresponding to the item information, and a pre-acquired original item image height value corresponding to the item information;
scaling each item image comprised in the item information group according to the corresponding generated item image size information, so as to obtain a scaled item image group; and
filling the scaled item image group into corresponding item placement regions in the target background image according to the determined item position information, so as to obtain the item information collocation diagram.

3. The method according to claim 1, wherein the determining a target background image and an item allocation relationship information corresponding to the target background image based on a set of determined item placement region types, a set of determined item placement scene types, the item information group and a pre-acquired set of background images comprises:
performing a background image selection step for the set of background images, wherein the background image selection step comprises:
selecting a background image from the set of background images;
acquiring at least one region type corresponding to at least one item placement region in the selected background image and at least one scene type corresponding to the at least one item placement region in the selected background image; and
allocating the item information having the item placement region type matched with the region type and having the item placement scene type matched with the scene type to the corresponding item placement region to obtain an allocation result, in response to the set of item placement region types containing a subset of item placement region types that has the same content as the at least one region type, and the set of item placement scene types containing a subset of item placement scene types that has the same content as the at least one scene type.

4. The method according to claim 3, wherein the background image selection step further comprises:
determining whether the allocation result comprises at least one same-category allocation result, wherein the same-category allocation result represents a plurality of same-category item information being allocated to at least one same-category item placement region, the plurality of same-category item information corresponds to the same item placement region type and the same item placement scene type, and the at least one same-category item placement region corresponds to the same region type and the same scene type; and
performing a same-category allocation result selection step for at least one same-category allocation result in response to the allocation result comprising the at least one same-category allocation result, wherein the same-category allocation result selection step comprises:
selecting a same-category allocation result from the at least one same-category allocation result;
determining the plurality of same-category item information corresponding to the selected same-category allocation result as a set of same-category item information;
determining the at least one same-category item placement region corresponding to the selected same-category allocation result as a set of same-category item placement regions;
sorting item image-size values corresponding to the same-category item information in the set of same-category item information in descending order, so as to obtain a sequence of sorted item image-size values;
sorting regional image-size values of the same-category item placement regions in the set of same-category item placement regions in descending order, so as to obtain a sequence of sorted regional image-size values;
determining a quantity of the same-category item information in the set of same-category item information to obtain a same-category item information quantity value; and
determining a quantity of the same-category item placement regions in the set of same-category item placement regions to obtain a same-category item placement region quantity value.

5. The method according to claim 4, wherein the same-category allocation result selection step further comprises:
allocating, according to the sequence of sorted item image-size values and the sequence of sorted regional image-size values, the item images comprised in the set of same-category item information to the corresponding item placement region to obtain a set of same-category item allocation relationships, in response to the same-category item information quantity value being less than or equal to the same-category item placement region quantity value; and
performing a background image processing step based on the set of same-category item allocation relationships, wherein the background image processing step comprises:
determining an image size difference value corresponding to each same-category item allocation relationship in the set of same-category item allocation relationships, so as to obtain a set of image size difference values;
adding the selected background image as a candidate background image to a pre-built set of initial candidate background images to obtain a set of candidate background images, in response to the set of image size difference values not containing any image size difference value less than a first target threshold, and a quantity of unselected same-category allocation result in the at least one same-category allocation result being equal to a second target threshold; and
determining a set of at least one same-category item allocation relationship obtained as the item allocation relationship information corresponding to the candidate background image, in response to the set of image size difference values not containing any image size difference value less than the first target threshold, and the quantity of unselected same-category allocation result in the at least one same-category allocation result being equal to the second target threshold.

6. The method according to claim 5, wherein the same-category allocation result selection step further comprises:
performing an item allocation relationship information generation step based on the sequence of sorted item image-size values and the sequence of sorted regional image-size values in response to the same-category item information quantity value being greater than the same-category item placement region quantity value, wherein the item allocation relationship information generation step comprises:
determining the item images comprised in the same-category item information corresponding to first N sorted item image-size values in the sequence of sorted item image-size values as a set of to-be-allocated item images, wherein a value of N is equal to the same-category item placement region quantity value;
allocating the set of to-be-allocated item images to a corresponding item placement region according to the sequence of sorted item image-size values and the sequence of sorted regional image-size values, so as to obtain a set of to-be-allocated item allocation relationships as a set of same-category item allocation relationships;
determining an image size difference value corresponding to each to-be-allocated item allocation relationship in the set of to-be-allocated item allocation relationships, so as to obtain a set of allocated-image size difference values;
sorting the set of allocated-image size difference values in descending order to obtain a sequence of sorted allocated-image size difference values, in response to the set of allocated-image size difference values not containing any allocated-image size difference value less than the first target threshold;
determining a quantity of unallocated item image in a set of unallocated item images, wherein the set of unallocated item images is a set of item images other than the set of to-be-allocated item images in the item images corresponding to the set of same-category item information;
allocating, according to the item image-size values corresponding to the set of unallocated item images and the sequence of sorted allocated-image size difference values, the unallocated item images to a corresponding item placement region to obtain a set of unallocated-item allocation relationships, in response to the quantity of unallocated item image being less than or equal to the same-category item placement region quantity value; and
performing the background image processing step by using the set of unallocated-item allocation relationships as the set of same-category item allocation relationships.

7. The method according to claim 6, wherein the determining a target background image and an item allocation relationship information corresponding to the target background image based on a set of determined item placement region types, a set of determined item placement scene types, the item information group and a pre-acquired set of background images further comprises:
determining whether the set of candidate background images is an empty set; and
selecting a candidate background image from the set of candidate background images as the target background image and determining the item allocation relationship information corresponding to the selected candidate background image as the item allocation relationship information corresponding to the target background image, in response to the set of candidate background images not being an empty set; or
determining a pre-acquired general background image as the target background image in response to the set of candidate background images being an empty set.

8. The method according to claim 2, wherein the item position information comprises an item arrangement relationship information; and
wherein the determining an item position information corresponding to the at least one item information for each item placement region in the at least one item placement region comprises:
determining at least one item information corresponding to the item placement region as a set of allocated item information;
acquiring an allocated-item real-size value corresponding to each allocated item information in the set of allocated item information, so as to obtain a set of allocated-item real-size values;
acquiring a regional image-size value of the item placement region and a regional real-size value of the item placement region;
generating a set of allocated-item image-size values based on the set of allocated-item real-size values, the regional image-size value and the regional real-size value;
sorting allocated-item image-size values in the set of allocated-item image-size values in ascending order to generate a sequence of sorted allocated-item image-size values;
determining a quantity of sorted allocated-item image-size values in the sequence of sorted allocated-item image-size values; and
generating the item arrangement relationship information in response to the quantity of sorted allocated-item image-size values being a third target threshold.

9. The method according to claim 8, wherein the determining an item position information corresponding to the at least one item information for each item placement region in the at least one item placement region further comprises:
performing an item arrangement relationship information determination step for the sequence of sorted allocated-item image-size values in response to the quantity of sorted allocated-item image-size values being greater than the third target threshold, wherein the item arrangement relationship information determination step comprises:
determining item images corresponding to first two sorted item image-size values in the sequence of sorted allocated-item image-size values as a first item image and a second item image;
generating a height ratio value and a width ratio value based on the first item image and the second item image;
generating a horizontal item arrangement information as the item arrangement relationship information in response to the height ratio value being greater than the width ratio value, wherein the horizontal item arrangement information comprises a left-right arrangement information and a horizontal ratio value, and the horizontal ratio value is equal to the width ratio value;
generating a vertical item arrangement information as the item arrangement relationship information in response to the height ratio value being less than or equal to the width ratio value, wherein the vertical item arrangement information comprises an up-down arrangement information and a vertical ratio value, and the vertical ratio value is equal to the height ratio value;
determining the first item image and the second item image as an integrated item image;
generating a sequence of updated allocated-item image-size values based on the sequence of sorted allocated-item image-size values and an allocated-item image-size value corresponding to the integrated item image;
determining a quantity of updated allocated-item image-size value in the sequence of updated allocated-item image-size values; and
generating the item arrangement relationship information in response to the quantity of updated allocated-item image-size value being the third target threshold; and
determining the generated item arrangement relationship information as the item arrangement relationship information corresponding to the at least one item information.

10. The method according to claim 9, wherein the generating a height ratio value and a width ratio value based on the first item image and the second item image comprises:
acquiring a height value of the first item image and a width value of the first item image as a first height value and a first width value;
acquiring a height value of the second item image and a width value of the second item image as a second height value and a second width value;
determining a ratio of the first height value to the second height value to obtain the height ratio value; and
determining a ratio of the first width value to the second width value to obtain the width ratio value.

11. The method according to claim 9, wherein the item position information comprises an item image position information; and
wherein the determining an item position information corresponding to the at least one item information for each item placement region in the at least one item placement region further comprises:
determining an item arrangement information quantity value of at least one item arrangement information, wherein the at least one item arrangement information is an item arrangement information comprised in the item arrangement relationship information corresponding to the at least one item information; and
performing an item image position information generation step for a regional simplified-representation information of the item placement region based on the item arrangement information quantity value, wherein the regional simplified-representation information comprises a regional upper-left corner coordinate and a regional lower-right corner coordinate, and the item image position information generation step comprises:
determining a simplified representation information of a first region in response to the item arrangement information quantity value being equal to a fourth target threshold, wherein the first region is a region in the item placement region, and the simplified representation information of the first region is the same as the regional simplified-representation information;
determining a midpoint coordinate of the first region, a width value of the first region and a height value of the first region; and
generating the item image position information based on the midpoint coordinate, the width value and the height value of the first region as well as a transformation matrix corresponding to the item placement region, wherein the item image position information comprises at least one of an item information, an item-region midpoint coordinate, an item-region width value, an item-region height value, or an item arrangement relationship information.

12. The method according to claim 11, wherein the item image position information generation step further comprises:
selecting an item arrangement information from the at least one item arrangement information in response to the item arrangement information quantity value being greater than the fourth target threshold, wherein the item arrangement information comprises a horizontal item arrangement information or a vertical item arrangement information;
dividing the item placement region into a first vertical division region and a second vertical division region as a first division region and a second division region according to a height division value, in response to the item arrangement information being the vertical item arrangement information;
dividing the item placement region into a first horizontal division region and a second horizontal division region as the first division region and the second division region according to a width division value, in response to the item arrangement information being the horizontal item arrangement information;
determining a division midpoint coordinate of the first division region, a division width value of the first division region and a division height value of the first division region;
generating the item image position information based on the division midpoint coordinate, the division width value and the division height value of the first division region as well as the transformation matrix corresponding to the item placement region;
re-performing the item image position information generation step by using a simplified representation information of the second division region as the regional simplified-representation information and using a value obtained by subtracting 1 from the item arrangement information quantity value as an item arrangement information quantity value; and
determining the generated item image position information as the item image position information corresponding to the at least one item information.

13. The method according to claim 12, wherein the item image position information comprises an item-region width value and an item-region height value; and
wherein the generating an item image size information for each item information in the item information group according to the item position information corresponding to the item information, a pre-acquired original item image width value corresponding to the item information and a pre-acquired original item image height value corresponding to the item information comprises:
in response to determining that the item arrangement information corresponding to the item information is the horizontal item arrangement information, determining an item width ratio value based on the item-region width value and the original item image width value, determining a product of the item width ratio value and the original item image width value as a target width value, determining a product of the item width ratio value and the original item image height value as a target height value, and determining the target width value and the target height value as the item image size information; or
in response to determining that the item arrangement information corresponding to the item information is the vertical item arrangement information, determining an item height ratio value based on the item-region height value and the original item image height value, determining a product of the item height ratio value and the original item image width value as a target width value, determining a product of the item height ratio value and the original item image height value as a target height value, and determining the target width value and the target height value as the item image size information.

14. The method according to claim 1, wherein the set of background images is generated by:
acquiring images of a plurality of scene types as the set of background images, wherein a background image in the set of background images comprises at least one item placement region;
resizing, for each background image in the set of background images, each of the at least one item placement region comprised in the background image to obtain an adjusted background image; and
determining a set of adjusted background images as the set of background images.

15. The method according to claim 14, wherein the resizing each of the at least one item placement region comprised in the background image comprises:
performing a resizing step for each item placement region in the at least one item placement region, wherein the resizing step comprises:
acquiring an adjustment item information according to the region type of the item placement region and the scene type of the item placement region, wherein the adjustment item information comprises an item real-size value;
determining a regional image-size value of the item placement region and a regional real-size value of the item placement region;
generating an item image-size value according to the item real-size value, the regional image-size value and the regional real-size value; and
resizing the item placement region according to the item image-size value.

16. An apparatus of generating an item information collocation diagram, comprising:
a first determination unit configured to determine, for an item category information comprised in each item information in a pre-acquired item information group, an item placement region type corresponding to the item category information and an item placement scene type corresponding to the item category information, wherein the item information in the item information group further comprises an item image;
a second determination unit configured to determine a target background image and an item allocation relationship information corresponding to the target background image based on a set of determined item placement region types, a set of determined item placement scene types, the item information group and a pre-acquired set of background images, wherein the target background image comprises at least one item placement region;
a third determination unit configured to determine, for each item placement region in the at least one item placement region, at least one item information corresponding to the item placement region based on the item allocation relationship information;
a fourth determination unit configured to determine an item position information corresponding to the at least one item information for each item placement region in the at least one item placement region; and
a filling unit configured to fill each item image comprised in the item information group into the corresponding item placement region in the target background image according to the corresponding determined item position information, so as to obtain the item information collocation diagram.

17. An electronic device, comprising:
one or more processors; and
a memory having one or more programs stored thereon, wherein the one or more programs, when executed by the one or more processors, are configured to cause the one or more processors to implement the method according to any one of claims 1 to 15.

18. A computer-readable medium having a computer program stored thereon, wherein the computer program, when executed by a processor, is configured to cause the processor to implement the method according to any one of claims 1 to 15.

19. A computer program product comprising a computer program, wherein the computer program, when executed by a processor, is configured to cause the processor to implement the method according to any one of claims 1 to 15.
